## Europäisches Patentamt
## European Patent Office
## Office européen des brevets

(19)

(11) Veröffentlichungsnummer: **0 113 795**
**B1**

(12) # EUROPÄISCHE PATENTSCHRIFT

(45) Veröffentlichungstag der Patentschrift:
**14.09.88**

(51) Int. Cl.⁴: **H 05 K 7/02**

(21) Anmeldenummer: **83104869.9**

(22) Anmeldetag: **17.05.83**

(54) Baugruppenträger für einseitig bestückte Flachbaugruppen in Planaranordnung.

(30) Priorität: **21.12.82 DE 3247316**

(43) Veröffentlichungstag der Anmeldung:
**25.07.84 Patentblatt 84/30**

(45) Bekanntmachung des Hinweises auf die Patenterteilung:
**14.09.88 Patentblatt 88/37**

(84) Benannte Vertragsstaaten:
**AT BE CH DE FR GB IT LI NL**

(56) Entgegenhaltungen:
FR - A - 2 135 328
FR - A - 2 293 122
US - A - 4 336 673

PROCEEDINGS OF THE S.I.D., Band 21, Nr. 2, Seiten
143-155, Los Angeles, US; K.T. BURNETTE et al.:
"Multi-mode matrix (MMM) modular flight display
development"

(73) Patentinhaber: **Siemens Aktiengesellschaft Berlin und München, Wittelsbacherplatz 2, D-8000 München 2 (DE)**

(72) Erfinder: **Wessely, Herrmann, Dipl.-Ing., Paul-Hösch-Strasse 1, D-8000 München 60 (DE)**
Erfinder: **Hatheier, Reinhard, Josef-Sammer-Strasse 19, D-8022 Grünwald (DE)**

**Beschreibung**

Die Erfindung betrifft einen Baugruppenträger für mehrere einseitig bestückte Flachbaugruppen in Planaranordnung.

Der Einsatz von schnellen, integrierten Schaltkreisen in Form von Mikrobausteinen beim Aufbau von grossen elektronischen Systemen, beispielsweise von Datenverarbeitungsanlagen, vermindert den Platzbedarf und erhöht wegen der geringen Leitungslänge die Schaltgeschwindigkeit. Die Mikrobausteine können in Flachbaugruppen mit hoher Packungsdichte verschaltet sein, wobei die dabei notwendigen zahlreichen Aussenanschlüsse auf engstem Raum auf der Unterseite verteilt sind und eine planare Anordnung auf einer als Baugruppenträger dienenden Leiterplatte bedingen. Um eine hohe Leiterdichte zu erreichen besteht diese vorwiegend aus miteinander verklebten, elektrisch isolierenden Schichten, auf welchen in parallelen Ebenen geätzte Leitungsmuster zur Signalleitung und Leistungsflächen zur Potentialeinspeisung verlaufen.

Bei einer Funktionseinheit aus mehreren, unterschiedlich bestückten Flachbaugruppen und einer Leiterplatte besteht während der Montage oder Wartung die Gefahr, dass Flachbaugruppen an falschen Einbauplätzen eingeordnet werden, was zumindest eine fehlerhafte Funktion mit daraus folgender Fehlersuche oder auch eine Beschädigung oder Zerstörung von Baugruppen zur Folge haben kann.

Der Erfindung lag daher die Aufgabe zugrunde, einen Baugruppenträger der oben genannten Art anzugeben, mit welchem eine eindeutige Zuordnung von Baugruppen und zugehörigen Einbauplätzen sichergestellt ist.

Diese Aufgabe wird gemäss dem kennzeichnenden Teil des Anspruchs 1 gelöst. Weiterbildungen der Erfindung ergeben sich aus den Unteransprüchen.

Im folgenden wird die Erfindung anhand eines bevorzugten Ausführungsbeispiels weiter beschrieben.

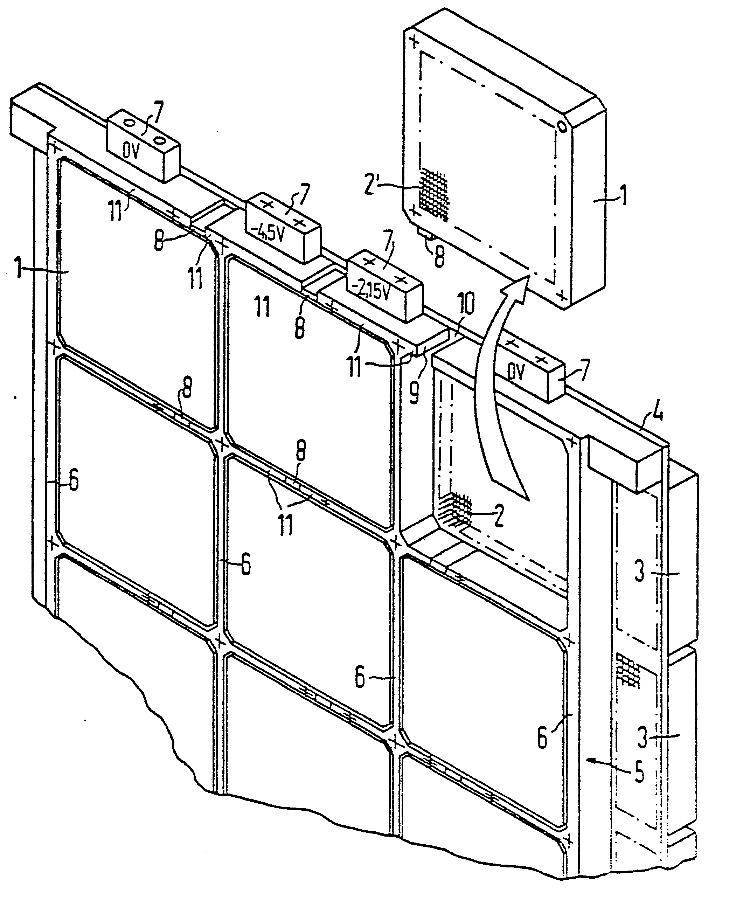

Die Figur zeigt einen Baugruppenträger mit Flachbaugruppen 1 in Planaranordnung. Der Baugruppenträger besteht aus einer Funktionseinheit aus einer Leiterplatte 4, aus einem darauf befestigten Gitterrahmen 5 und aus mehreren Flachbaugruppen 1.

Die Flachbaugruppen 1 sind in ihrer äusseren Form durch ein Steckverbinderteil bestimmt, welches die vier schmalen Ränder der Flachbaugruppe 1 einfasst, und auf dessen einer Flachseite eine Vielzahl von Kontaktelementen 2' in rasterartig verteilte Kammern eingesetzt ist. Auf der zweiten Flachseite ist eine metallische Kühlplatte in das Steckverbinderteil eingebettet, unter welcher, in der Figur nicht sichtbar, integrierte Mikrobausteine verschaltet sind.

Die Kontaktelemente 2' bestehen aus Stiften oder Kontaktfedern, deren Gegenstücke 2 innerhalb eines Gitterzwischenraumes auf der Leiterplatte 4 befestigt sind. Zur Veranschaulichung ist eine der Flachbaugruppen 1 in Pfeilrichtung aus dem zugehörigen Gitterzwischenraum nach oben herausgeklappt, und gibt somit die Sicht frei auf die Kontaktelemente 2' und ihre Gegenstücke 2. Die übrigen Flachbaugruppen 1 sind in planarer Anordnung in die Gitterzwischenräume gesteckt. Die Leiterplatte 4 besteht aus mehreren, miteinander verklebten isolierenden Schichten, auf welchen geätzte Leitermuster zur Signalleitung und Leiterflächen zur Potentialeinspeisung verlaufen. Von den Signalleitungen und den Potentialflächen führen Durchkontaktierungen zu den Kontaktelementen 2'. Zum externen Anschluss der Funktionseinheit ist die Leiterplatte 4 auch mit Steckerleisten 3 versehen.

Der Gitterrahmen 5 ist auf der die Flachbaugruppen 1 tragenden Bestückungsseite mit der Leiterplatte 4 verschraubt. Er ist aus Gitterelementen zusammengesetzt, die jeweils aus einer Längsschiene 6 und mehreren die Querstreben des Gitters bildenden Schienenfortsätzen 11 bestehen, wobei die Gitterzwischenräume formschlüssige Einsteckkammern für jeweils eine Flachbaugruppe 1 bilden. Die Längsschienen 6 verlaufen parallel zueinander und reichen von einem Ende der Leiterplatte 4 zum anderen. Die beiden, die äusseren Ränder des Gitters bildenden Schienen weisen nur an ihrer Innenseite die senkrecht abstehenden Schienenfortsätze 11 auf, während die übrigen Schienen 6 auf beiden Seiten mit Schienenfortsätzen 11 versehen sind. An den Stirnseiten 9 der Gitterfortsätze 11 sind zum benachbarten Gitterrahmen Trennfugen 10 ausgespart, die durch einen Isolationskörper ausgefüllt sind. Dieser sitzt als Kodierkörper 8 höckerartig auf dem Aussenrand der dem Gitterzwischenraum zugeordneten Flachbaugruppe 1.

An beiden Enden der Gitterelemente sind an den Aussenseiten der Schienenfortsätze 11 jeweils Kontaktierungsvorrichtungen 7 zum Anlegen der Betriebspotentiale befestigt. Sie bestehen aus Schraubverbindungen, mit welchen die zu einer Stromversorgung führenden Leitungen angeklemmt sind (nicht dargestellt). Jedes Gitterelement ist mit einem Potential beaufschlagt, das sich vom Potential des benachbarten Gitterelementes unterscheidet. An den beiden äusseren Gitterelementen liegt beispielsweise das Erdpotential, während an die beiden mittleren Gitterelemente beispielsweise 4,5 Volt oder +2,15 Volt angelegt sind. Beim Einsetzen der Flachbaugruppen in den Gitterrahmen 5 werden diese bezüglich der Kontaktelemente 2' und deren Gegenstücke 2 zentriert und erhalten beim Einstecken eine Führung, die eine Beschädigung der Kontaktierungselemente 2' und ihrer Gegenstücke 2 verhindert. Mittels Durchkontaktierungen zu den entsprechenden Schichten der Leiterplatte 4 werden die Mikrobausteine der Flachbaugruppe 1 mit den Leitungsmustern und den Potentialflächen der Leiterplatte 4 verbunden. Die Potentialeinspeisung erfolgt über den Gitterrahmen 5, welcher über Durchkontaktierungen mit den Potentialebenen der Leiterplatte 4 verbunden ist. Die Durchkontaktierungen sind bevorzugt an den Stellen ausgeführt, die nahe an grösseren Spannungsabfällen auf den Potentialflächen liegen.

Die Kodierung der Einbauplätze bzw. Gitterzwischenräume und der zugehörigen Flachbaugruppen 1 erfolgt dadurch, dass jeder Gitterzwischenraum an seiner Innenseite, d.h. an den die Berührungsflächen zur Flachbaugruppe 1 bildenden Kammerwänden mindestens eine Aussparung 10 zur Aufnahme des auf dem Rand der Flachbaugruppe 1 angebrachten Kodierkörpers 8 aufweist. Im Ausführungsbeispiel sind diese Aussparungen 10 als Trennfugen zwischen den stumpf aufeinanderstossenden Schienenfortsätzen 11 von benachbarten Gitterelementen ausgebildet. Die Kodierkörper 8 sind den Abmessungen der Trennfugen jeweils angepasst.

Die Länge der Schienenfortsätze 11 ist vom Gitterzwischenraum zu Gitterzwischenraum unterschiedlich, so dass zumindest die Art der Trennfuge und des zugehörigen Kodierkörpers 8 den Gitterzwischenraum eindeutig kennzeichnen. Auch unterschiedliche Breiten der Trennfugen und der Kodierkörper 8 sowie eine Kombination beider Kennzeichnungen legen die Einbauplätze eindeutig fest.

### Patentansprüche

1. Baugruppenträger für mehrere einseitig bestückte Flachbaugruppen in Planaranordnung, dadurch gekennzeichnet, dass auf der Bestückungsseite einer Verdrahtungsplatte (4) ein Gitterrahmen (5) befestigt ist, dessen Gitterzwischenräume als formschlüssige Einsteckkammern für jeweils eine Flachbaugruppe (1) ausgebildet sind und an ihrer Innenseite mindestens eine Aussparung (10) zur Aufnahme eines auf dem Rand der Flachbaugruppe (1) angebrachten Kodierkörpers (8) aufweisen.

2. Baugruppenträger nach Anspruch 1, dadurch gekennzeichnet, dass der Gitterrahmen (5) aus Gitterelementen zusammengesetzt ist, die jeweils aus einer Längsschiene (6) mit mehreren, die Querstreben des Gitters bildenden, zumindest auf einer Seite senkrecht abstehenden Schienenfortsätzen (11) bestehen, und dass als Aussparungen (10) Trennfugen zwischen den freien Stirnflächen (9) der Schienenfortsätze (11) und den benachbarten Gitterelementen dienen.

3. Baugruppenträger nach einem der Ansprüche 1 oder 2, dadurch gekennzeichnet, dass die Schienenfortsätze (11) unterschiedlich lang sind.

4. Baugruppenträger nach einem der Ansprüche 1 bis 3, dadurch gekennzeichnet, dass die den Schienenfortsätzen (11) zugeordneten Trennfugen unterschiedlich breit sind.

5. Baugruppenträger nach einem der Ansprüche 2 bis 5, dadurch gekennzeichnet, dass die Gitterelemente jeweils mit unterschiedlichen Spannungspotentialen zum Anlegen an die Flachbaugruppen (1) beaufschlagt sind, und dass die Kodierkörper (8) aus einem elektrisch isolierenden Material bestehen.

### Claims

1. An assembly carrier for a plurality of flat assemblies, loaded on one side, in a planar arrangement, characterised in that on the assembly side of a circuit board (4) there is attached a grid frame (5) whose grid spaces are in the form of form-fitting plug-in chambers each for one flat assembly (1) and on their inside each contain a recess (10) which accommodates a coder body (8) arranged at the edge of the flat assembly (1).

2. An assembly carrier as claimed in Claim 1, characterised in that the grid frame (5) is made up of grid elements, each of which consists of a longitudinal bar (6) with a plurality of bar projections (11) which project at right angles at least on one side and which form the cross-members of the grid, and that the recesses (10) consist of separating gaps between the free end faces (9) of the bar projections (11) and the adjacent grid elements.

3. An assembly carrier as claimed in one of Claims 1 or 2, characterised in that the bar projections (11) differ in length.

4. An assembly carrier as claimed in one of Claims 1 to 3, characterised in that the separating gaps which are assigned to the bar projections (11) differ in width.

5. An assembly carrier as claimed in one of Claims 2 to 5, characterised in that the grid elements are each supplied with different voltage potentials for connection to the flat assemblies (1), and that the coder bodies (8) consist of an electrically insulating material.

### Revendications

1. Porte-modules prévu pour plusieurs modules plats munis de composants sur une seule face et agencés selon une disposition planar, caractérisé par le fait que sur la face de montage des composants d'une plaque de câblage (4) se trouve fixé un cadre en forme de grille (5), dont les cavités sont réalisées sous la forme de chambres d'enfichage de forme adaptée pour des modules plats respectifs (1) et comportent, sur leur côté intérieur, au moins un évidement (10) servant à recevoir un organe de codage (8) disposé sur le bord du module plat (1).

2. Porte-modules suivant la revendication 1, caractérisé par le fait que le cadre en forme de grille (5) est formé par la réunion d'éléments de grille, qui sont constitués chacun par un rail longitudinal (6) comportant plusieurs appendices saillants (11) qui forment les barres transversales de la grille et font saillie perpendiculairement au moins d'un côté, et que les évidements (10) sont formés par des joints de séparation présents entre les surfaces frontales libres (9) des appendices saillants (11) du rail et les éléments de grille voisins.

3. Porte-modules suivant l'une des revendications 1 ou 2, caractérisé par le fait que les appendices saillants (11) des rails possèdent des longueurs différentes.

4. Porte-modules suivant l'une des revendications 1 à 3, caractérisé par le fait que les joints de séparation associés aux appendices saillants (11) des rails possèdent des largeurs différentes.

5. Porte-modules suivant l'une des revendications 2 à 5, caractérisé par le fait que les éléments de grille sont chargés respectivement par des potentiels de tension différents destinés à être appliqués aux modules plats (1) et que les organes de codage (8) sont réalisés en un matériau électriquement isolant.